# EUROPÄISCHE PATENTSCHRIFT

(11) **EP 1 588 436 B1**
(45) Veröffentlichungstag und Bekanntmachung des Hinweises auf die Patenterteilung: **01.10.2014**
(21) Anmeldenummer: 04706121.3
(22) Anmeldetag: 29.01.2004
(51) Int. Cl.: H01L 33/48, H01L 33/52, H01L 33/54

(54) **ELEKTROMAGNETISCHE STRAHLUNG AUSSENDENDES UND/ODER EMPFANGENDES HALBLEITER-BAUELEMENT**
SEMICONDUCTOR COMPONENT EMITTING AND/OR RECEIVING ELECTROMAGNETIC RADIATION
COMPOSANT A SEMI-CONDUCTEUR EMETTANT ET/OU RECEVANT UN RAYONNEMENT ELECTROMAGNETIQUE

(30) Priorität: 30.01.2003 DE 10303727
(43) Veröffentlichungstag der Anmeldung: 26.10.2005
(73) Patentinhaber: OSRAM Opto Semiconductors GmbH, 93055 Regensburg (DE)
(72) Erfinder: ARNDT, Karlheinz, 93077 Bad Abbach (DE); BOGNER, Georg, 93138 Lappersdorf (DE); BRAUNE, Bert, 93173 Wenzenbach (DE); WAITL, Günter, 93049 Regensburg (DE)
(74) Vertreter: Epping - Hermann - Fischer
(86) Internationale Anmeldenummer: PCT/DE2004/000136
(87) Internationale Veröffentlichungsnummer: WO 2004/068594

(56) Entgegenhaltungen:
- WO-A-01/82385
- WO-A-03/019679
- DE-A- 10 122 002
- US-A- 5 821 615
- PATENT ABSTRACTS OF JAPAN Bd. 1997, Nr. 05, 30. Mai 1997 (1997-05-30) -& JP 09 027643 A (STANLEY ELECTRIC CO LTD), 28. Januar 1997 (1997-01-28)
- PATENT ABSTRACTS OF JAPAN Bd. 1996, Nr. 06, 28. Juni 1996 (1996-06-28) -& JP 08 032120 A (ROHM CO LTD), 2. Februar 1996 (1996-02-02)

## Beschreibung

Die Erfindung bezieht sich auf ein elektromagnetische Strahlung aussendendes und/oder empfangendes Halbleiter-Bauelement gemäß dem Oberbegriff des Patentanspruches.

Sie bezieht sich insbesondere auf ein oberflächenmontierbares optoelektronisches Bauelement, insbesondere auf Leiterrahmen(Leadframe)-Basis, bei dem der Halbleiterchip in einer Ausnehmung eines Gehäuse-Grundkörpers angeordnet und dort befestigt ist. Der Gehäuse-Grundkörper ist vorzugsweise vorgefertigt, bevor der Halbleiterchip in die Ausnehmung montiert wird.

Solche Halbleiter-Bauelemente sind beispielsweise aus Siemens Components 26 (1991) Heft 4, Seiten 147 bis 149 bekannt. Herkömmlich werden als Umhüllungsmasse beispielsweise auf Epoxidharz basierende Vergußmaterialien verwendet. Derartige Vergußmaterialien sind aber oftmals anfällig gegenüber UV-Strahlung.

Um die UV-Beständigkeit von strahlungsemittierenden und/oder strahlungsempfangenden optoelektronischen Halbleiterbauelementen zu verbessern ist die Verwendung von Umhüllungsmassen aus Silikonharz vorgeschlagen. Diese bringen aber die Schwierigkeit mit sich, dass sie mit den herkömmlich verwendeten Materialien für den Gehäuse-Grundkörper keine so feste Bindung eingehen, wie es beispielsweise Epoxidharz tut. Deshalb besteht bei der Verwendung von Silikonharz als Umhüllungsmasse eine erhöhte Gefahr, dass bei mechanischer oder thermischer Belastung zwischen Gehäuse-Grundkörper und Umhüllungsmasse Delamination auftritt, die am oberen Rand der Ausnehmung startet und sich in die Ausnehmung hinein fortpflanzt. Dies führt zu einem Lichtverlust aufgrund zusätzlicher reflektierender Flächen im Delaminationsbereich. Zudem kann es im schlimmsten Fall zur völligen Ablösung der Chipumhüllung aus dem Gehäuse-Grundkörper kommen.

Die Druckschrift JP 09-027643 A offenbart ein Licht empfangendes oder emittierendes Element mit einem Stufenteil und einem Harzführungsgraben in einer Ausnehmung eines Gehäuses.

Die Druckschrift JP 08-032120 A offenbart eine oberflächenemittierende Anzeigevorrichtung mit einer Mehrzahl von Leuchtdiodenelementen und einer reflektierenden Platte auf einem Substrat. Die reflektierende Platte umgibt die Leuchtdiodenelemente zur Ausbildung eines Harz-Einspritzabschnitts und hat einen Grabenabschnitt an einer oberen Oberfläche.

Die Druckschrift WO 01/82385 A1 offenbart ein strahlungsemittierendes Halbleiterbauelement mit einem Halbleiterkörper, der in einem napfartigen Bereich angeordnet ist, der in einer Ausnehmung angeordnet ist und ein Lumineszenzkonversionselement enthält.

Der vorliegenden Erfindung liegt die Aufgabe zugrunde, ein Halbleiterbauelement der eingangs genannten Art, insbesondere ein oberflächenmontierbares Halbleiterbauelement der eingangs genannten Art bereitzustellen, bei dem trotz Verwendung einer Umhüllungsmasse, deren Bindung zum Gehäuse-Grundkörper gegenüber mechanischer Belastung stark anfällig ist, die Gefahr einer Delamination zwischen Umhüllungsmasse und Gehäuse-Grundkörper verringert ist.

Diese Aufgabe wird durch ein Halbleiterbauelement mit den Merkmalen des Patenanspruches 1 gelöst.

Vorteilhafte Ausführungsformen und Weiterbildungen des Halbleiterbauelements sind Gegenstand der Ansprüche 2 bis 12.

Bei einem Halbleiterbauelement gemäß der Erfindung weist die Ausnehmung eine Chipwanne auf, in der der Halbleiterchip befestigt ist und die Chipwanne innerhalb der Ausnehmung zumindest teilweise, das heißt über einen Teil des Umfangs der Chipwanne, von einem Graben umgeben ist. Zwischen der

Chipwanne und dem Graben ist folglich ein Wall des Gehäuse-Grundkörpers ausgebildet. Der Scheitel des Walls liegt gesehen von einer Bodenfläche der Chipwanne insgesamt unterhalb des Niveaus der Vorderseite des Gehäuse-Grundkörpers. Die Vorderseite ist hierbei diejenige äußere Oberfläche des Gehäuse-Grundkörpers, von der aus die Ausnehmung in den Gehäuse-Grundkörper eindringt, das heißt, ist die Seite des Bauelements, über die elektromagnetische Strahlung emittiert und/oder empfangen wird.

Bei dem Halbleiterbauelement ist die Umhüllungsmasse derart in die Ausnehmung gefüllt, dass sie von der Chipwanne aus über den Wall in den Graben greift. Im Graben ist einstückig mit der übrigen Umhüllungsmasse ein zumindest teilweise umlaufendes, vorzugsweise durchgängiges Verankerungs- oder Dichtband, insbesondere einen Verankerungs- oder Dichtring aus Umhüllungsmaterial ausgebildet. Vorzugsweise basiert die Umhüllungsmasse auf Silikon und weist diese eine gelartige Konsistenz auf.

Gemäß der Erfindung ist an den Wall mindestens ein Verankerungselement, vorzugsweise eine an den Gehäuse-Grundkörper angeformte Nase oder Rippe oder eine Furche ausgebildet.

Bei mehreren Verankerungselementen sind diese vorzugsweise gleichmäßig, das heißt mit im Wesentlichen gleichen Abständen untereinander, auf dem Wall über dessen Länge verteilt angeordnet. Bei einer besonderen Ausführungsform sind die Verankerungselemente derart angeordnet, dass diese jeweils paarweise statistisch oder exakt gegenüberliegend angeordnet sind. Die Umhüllungsmasse überspannt vorzugsweise das (die) Verankerungselement(e). Der Füllstand innerhalb der Ausnehmung ist insbesondere so hoch, dass die Umhüllungsmasse den Wall und ggf. die Verankerungselemente vollständig abdeckt. Dies erleichtert die Weiterverarbeitung der Bauelement mittels herkömmlicher Pick-and-Place-Vorrichtungen.

Bei einer anderen Ausführungsform des Bauelements ist die Umhüllungsmasse schlaufenartig um das (die) Verankerungselement(e) gelegt ist, derart, dass das (die) Verankerungselement(e) zumindest teilweise aus der Umhüllungsmasse herausragt (herausragen). Die Umhüllungsmasse bildet besonders bevorzugt im Graben eine durchgängigen Verankerungsring um die Chipwanne aus, der zudem Dichtfunktion aufweisen kann.

Bei einer besonderen Ausführungsform des Bauelements ist die Chipwanne als Reflektorwanne für die vom Halbleiterchip ausgesandte und/oder empfangene Strahlung ausgebildet.

Bei einer besonders bevorzugten Ausführungsform des Bauelements ist der Gehäuse-Grundkörper an einem metallischen Leiterrahmenband (Leadframeband) mittels Spritzen oder Pressen vorgefertigt.

In die Umhüllungsmasse kann auf einfache Weise mit mindestens einem Leuchtstoffmaterial eingemischt werden, das einen Teil der vom Halbleiterchip emittierten Strahlung absorbiert und Strahlung mit im Vergleich zur absorbierten Strahlung geänderter Wellenlänge emittiert. Dadurch können auf einfache Weise Leuchtdiodenbauelemente hergestellt werden, die mischfarbiges Licht oder farbangepaßtes Licht aussenden.

Bei einer bevorzugten Weiterbildung des Bauelements weist der Wall mindestens eine Aussparung auf, durch die mindestens ein Chipanschlußdraht vom Halbleiterchip zu einem Drahtanschlußbereich eines elektrischen Anschlussleiters des Bauelements geführt ist.

Bei einem Bauelement gemäß der Erfindung ist es für eine zuverlässige Funktion vorteilhafterweise nicht notwendig, die Umhüllungsmasse beispielsweise mittels einer linsenartigen Abdeckung, wie sie in der US 6,274,924 beschrieben ist, oder mittels eines anderen Abdeckmittels auf dem Gehäuse-Grundkörper zu schützen.

Weitere Vorteile und vorteilhafte Weiterbildungen des Bauelements ergeben sich aus den im Folgenden unter Bezugnahme auf die Figuren beschriebenen Ausführungsbeispielen. Es zeigen:
Figur 1, eine schematische Darstellung einer Schnittansicht durch ein erstes Ausführungsbeispiel eines erfindungsgemäßen Bauelements,
Figur 2, eine schematische Darstellung einer Schnittansicht durch ein zweites Ausführungsbeispiel eines erfindungsgemäßen Bauelements,
Figur 3, eine schematische Darstellung einer Draufsicht auf den Gehäuse-Grundkörper des ersten und des zweiten Ausführungsbeispieles,
Figur 4, eine schematische Darstellung einer Schnittansicht des Gehäuse-Grundkörpers des ersten und des zweiten Ausführungsbeispieles,
Figur 5, eine schematische Darstellung einer perspektivischen Ansicht eines Gehäuse-Grundkörpers des ersten und des zweiten Ausführungsbeispieles, beispielsweise vorgesehen für ein oberflächenmontierbares Leuchtdioden(LED)-Bauelement oder Infrarot emittierendes Dioden(IRED)-Bauelement,
Figur 6, eine schematische Darstellung einer perspektivischen Ansicht eines Gehäuse-Grundkörpers einer Abwandlung, beispielsweise vorgesehen für ein oberflächenmontierbares Leuchtdioden(LED)-Bauelement oder Infrarot emittierendes Dioden(IRED)-Bauelement, und
Figur 7, eine schematische Darstellung einer Schnittansicht des Gehäuse-Grundkörpers der Abwandlung von Figur 6.

In den Figuren sind gleiche oder gleichwirkende Bestandteile der Ausführungsbeispiele jeweils gleich bezeichnet und mit den gleichen Bezugszeichen versehen. Die Figuren sind grundsätzlich nicht als maßstabsgerechte Darstellungen von realen Vorrichtungen gemäß der Erfindung anzusehen.

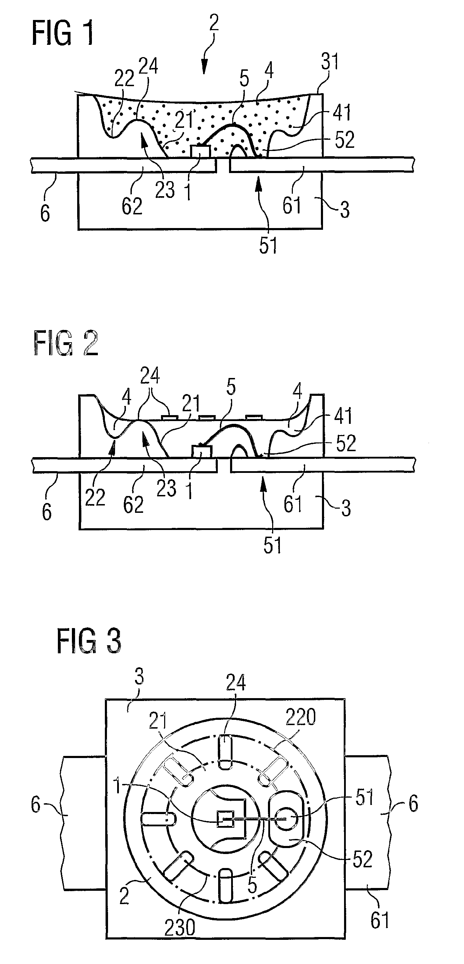

Bei dem in Figur 1 schematisch dargestellten Bauelement handelt es sich um ein oberflächenmontierbares Leuchtdiodenbauelement mit einem gegebenenfalls unter anderem UV-Strahlung emittierenden Leuchtdiodenchip 1, beispielsweise einen GaNbasierten sichtbares blaues Licht emittierenden Leuchtdiodenchip, der gewollt oder nicht gewollt auch UV-Strahlung emittiert. Derartige Bauelemente eignen sich grundsätzlich auch für die Anwendung bei andersartigen Leuchtdiodenchips, ebenso wie für IR-emittierende Bauelemente, die insbesondere für Hochtemperaturanwendungen vorgesehen sind.

Der Leuchtdiodenchip 1 ist auf einem elektrischen Chipanschlußteil eines metallischen Leiterrahmens (Leadframe) 6 montiert und über einen Bonddraht 5 mit einem Drahtanschlußbereich 51 eines vom Chipanschlußteil 62 elektrisch getrennten elektrischen Drahtanschlußteiles 61 des Leiterrahmens 6 verbunden.

Am Leiterrahmen befindet sich ein beispielsweise aus Kunststoff spritzgegossener oder spritzgepresster Gehäuse-Grundkörper 3 mit einer Ausnehmung 2. Die Ausnehmung 2 weist eine Chipwanne 21 auf, in der sich der Leuchtdiodenchip 1 befindet. Um die Chipwanne 21, die vorliegend als Reflektorwanne für eine vom Leuchtdiodenchip 1 ausgesandte elektromagnetische Strahlung ausgebildet ist, verläuft ein Graben 22 (in Figur 3 durch die strichpunktierte Linie 220 angedeutet), so dass zwischen der Chipwanne 21 und diesem Graben 22 einen Wall 23 (in Figur 3 durch die strichpunktierte Linie 230 angedeutet), ausgebildet ist.

Der Wall 23 weist an einer Stelle eine Aussparung 52 zum Drahtanschlußbereich 51 hin auf, durch die der Bonddraht 5 zum Drahtanschlußbereich 51 hin geführt ist.

Auf dem Wall 23 ist eine Mehrzahl von Verankerungselementen 24 in Form von Nasen oder Rippen ausgebildet, die bis auf den Bereich, wo die Ausnehmung für den Bonddraht 5 ist, beispielsweise gleichmäßig um die Chipwanne 21 herum auf dem Wall 23 verteilt sind. Die Verankerungselemente 24 beginnen am oberen Auslauf des Walls 23 und stehen nur zum Teil in den Graben 22 hinein, so dass, gesehen von der Chipwanne 21 hinter den Verankerungselementen 24 der Graben 22 durchgehend umlaufend ist.

Der Scheitel des Walls 23 einschließlich der Verankerungselemente 24 liegt, gesehen vom Boden der Chipwanne 21 aus, über die gesamte Länge des Walls 23 unterhalb der Höhe der Vorderseite 31 des Gehäuse-Grundkörpers 3.

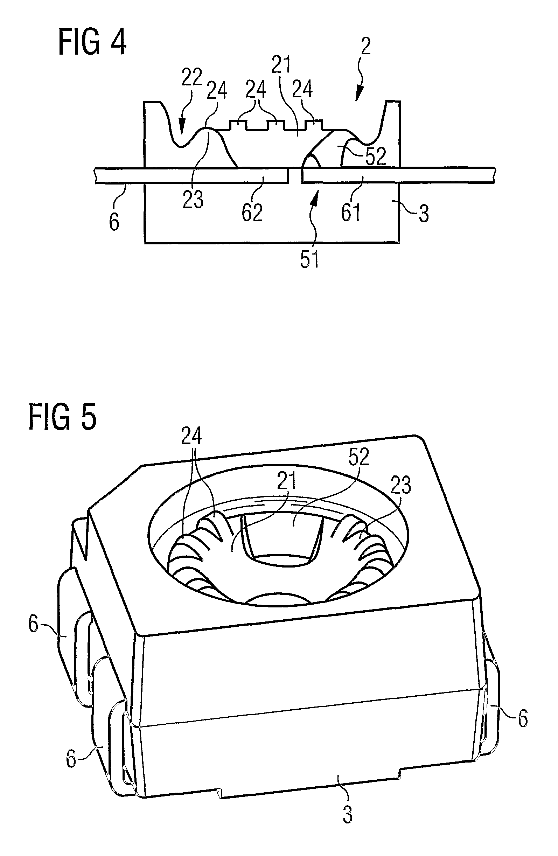

Gehäuse-Grundkörper 3, Wall 23 und Verankerungselemente 24 sind, wie aus den Figuren 3 bis 5 ersichtlich, vorzugsweise einstückig ausgebildet und werden in einem einzigen Spritzguß- oder Spritzpressvorgang ausgebildet.

In der Ausnehmung 2 befindet sich eine Umhüllungsmasse 4 aus strahlungsdurchlässigem, beispielsweise klarem, gelartigem Vergußmaterial auf Silikonbasis, der ein Leuchtstoffpulver 7, beispielsweise ein auf YAG:Ce, auf TbAG:Ce oder auf TbYAG:Ce basierender Leuchtstoff beigemischt ist. Solche Leuchtstoffe sind beispielsweise aus der WO 98/12757 und aus der WO 01/08452 bekannt. Die Umhüllungsmasse 4 in der Ausnehmung 2 füllt die Chipwanne 21, erstreckt sich über den Wall 23 und die Verankerungselemente 24 und bildet von der Chipwanne 21 aus gesehen hinter dem Wall 23, hier also im Graben 22, einen Verankerungsring 41 aus, der zudem auch eine Dichtfunktion übernehmen kann. Auf ihrer vom Leuchtdiodenchip 1 abgewandten Seite weist die Umhüllungsmasse 4 eine konkave freie Oberfläche auf.

Bei Bauelementen, die ausschließlich originäre Strahlung des Leuchtdiodenchips aussenden sollen, kann die Umhüllungsmasse 4 ausschließlich ein klares, gelartiges Vergußmaterial auf Silikonbasis sein. Alternativ kann dieses mit Diffusorpartikeln versehen und von diesem eingetrübt sein.

Das in Figur 2 dargestellte zweite Ausführungsbeispiel unterscheidet sich von dem oben in Verbindung mit Figur 1 beschriebenen Ausführungsbeispiel insbesondere dadurch, dass die Ausnehmung 4 nicht so hoch mit Umhüllungsmasse 4 gefüllt ist, dass die Verankerungselemente vollständig von dieser überdeckt sind, sondern dass die Verankerungselemente 24 die Umhüllungsmasse 4 durchdringen. Die Umhüllungsmasse 4 ist folglich schlaufenartig um die Verankerungselemente 24 gelegt. In diesem Ausführungsbeispiel ist beispielhaft eine klare Umhüllungsmasse 4 auf Silikonbasis ohne Leuchtstoff vorgesehen. Eine solche kann selbstverständlich auch bei den anderen Ausführungsbeispielen verwendet werden.

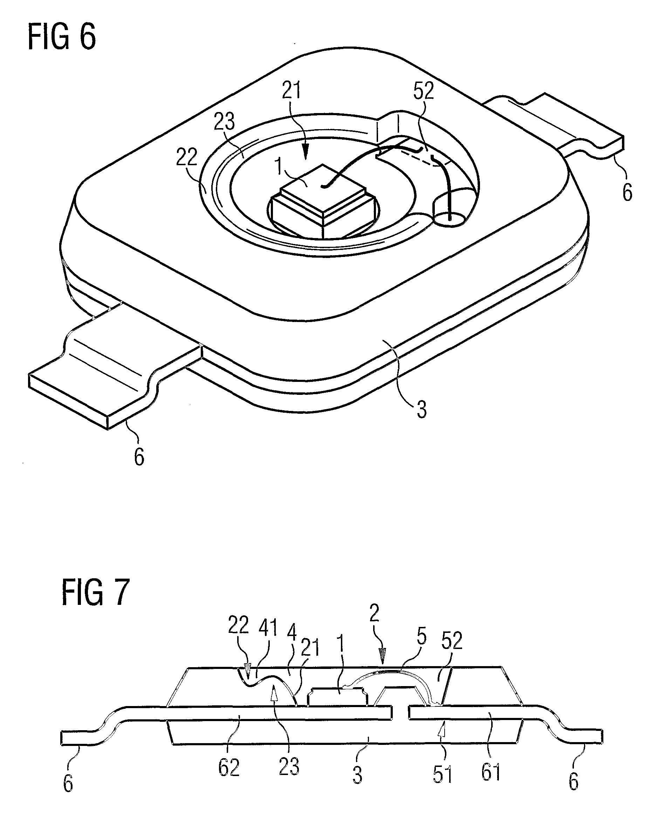

Die in den Figuren 6 und 7 schematisch dargestellte Abwandlung unterscheidet sich von dem oben in Verbindung mit Figur 1 beschriebenen Ausführungsbeispiel insbesondere dadurch, dass an dem Wall 23 keine Verankerungselemente vorhanden sind.

Den Ausführungsbeispielen entsprechende Gehäusegrundkörper und Umhüllungsmassen können auch für strahlungsempfangende Halbleiterchips, wie Photodiodenchips, eingesetzt werden. An die Stelle des Leuchtdiodenchips 1 kann dann der Photodiodenchip treten. Ebenso eignet sich die erfindungsgemäße Bauform für den Einsatz bei Laserdiodenbauelementen, Detektorbauelementen und für Hochtemperaturanwendungen.

## Patentansprüche

1. Strahlung aussendendes und/oder empfangendes Halbleiter-Bauelement mit mindestens einem Strahlung aussendenden und/oder empfangenden Halbleiterchip (1), der in einer Ausnehmung (2) eines einstückigen Gehäuse-Grundkörpers (3) angeordnet ist und dort mit einem Umhüllungselement (4) überdeckt ist, die für eine vom Halbleiterchip (1) ausgesandte und/oder empfangene elektromagnetische Strahlung gut durchlässig ist, wobei
der Gehäuse-Grundkörper in der Ausnehmung (2) eine Chipwanne (21), in der der Halbleiterchip (1) befestigt ist, und einen die Chipwanne (21) zumindest teilweise umlaufenden Graben (22) aufweist, derart, dass zwischen der Chipwanne (21) und dem Graben (22) der Gehäuse-Grundkörper (3) einen Wall (23) aufweist, dessen Scheitel gesehen von einer Bodenfläche der Chipwanne (21) unterhalb des Niveaus derjenigen Oberfläche des Gehäuse-Grundkörpers (3) liegt, von der aus die Ausnehmung (2) in den Gehäuse-Grundkörper (3) führt,
- die Umhüllungsmasse (4) einstückig ausgebildet ist und zur Verminderung des Risikos einer Delamination zwischen Umhüllungsmasse (4) und Gehäuse-Grundkörper (3) aus der Chipwanne (21) heraus über den Wall in den Graben (22) greift,
**dadurch gekennzeichnet, daß**
an dem Wall (23) mindestens ein Verankerungselement (24) ausgebildet ist, das in die Umhüllungsmasse ragt.

2. Halbleiterbauelement nach Anspruch 1,
**dadurch gekennzeichnet, daß**
die Umhüllungsmasse (4) eine gelartige Konsistenz aufweist.

3. Halbleiterbauelement nach Anspruch 1 oder 2,
**dadurch gekennzeichnet, daß**
an den Wall (23) verteilt mehrere der Verankerungselemente (24) angeordnet sind, die ausgehend von dem Wall in die Umhüllungsmasse ragen.

4. Halbleiterbauelement nach Anspruch 3,
**dadurch gekennzeichnet, daß**
die Verankerungselemente (24) gleichmäßig um die Chipwanne an dem Wall verteilt sind.

5. Halbleiterbauelement nach einem der vorhergehenden Ansprüche,
**dadurch gekennzeichnet, daß**
das (die) Verankerungselement(e) (24) als aus dem Wall herausragende Verankerungsnase(n) oder -rippe(n) ausgebildet ist (sind) und die Umhüllungsmasse (4) schlaufenartig um das (die) Verankerungselement(e) (24) gelegt ist, derart, dass das (die) Verankerungselement(e) (24) zumindest teilweise aus der Umhüllungsmasse (4) herausragt (herausragen).

6. Halbleiterbauelement nach einem der vorhergehenden Ansprüche,
**dadurch gekennzeichnet, daß**
das (die) Verankerungselement(e) als aus dem Wall herausragende Verankerungsnase(n) oder -rippe(n) ausgebildet ist (sind) und die Umhüllungsmasse (4) das (die) Verankerungselement(e) überspannt.

7. Halbleiterbauelement nach einem der vorangehenden Ansprüche,
**dadurch gekennzeichnet, daß**
die Chipwanne (21) als Reflektorwanne für die vom Halbleiterchip ausgesandte und/oder empfangene Strahlung ausgebildet ist.

8. Halbleiterbauelement nach einem der vorangehenden Ansprüche,
**dadurch gekennzeichnet, daß**
in die Umhüllungsmasse (4) mindestens ein Leuchtstoffmaterial (7) eingemischt ist, das einen Teil der vom Halbleiterchip emittierten Strahlung absorbiert und Strahlung mit im Vergleich zur absorbierten Strahlung geänderter Wellenlänge emittiert.

9. Halbleiterbauelement nach einem der vorangehenden Ansprüche,
**dadurch gekennzeichnet, daß**
der Wall mindestens eine Aussparung (52) aufweist, durch die mindestens ein Chipanschlußdraht (5) vom Halbleiterchip (1) zu einem Drahtanschlußbereich (51) eines elektrischen Anschlussleiters (61) des Bauelements geführt ist.

10. Halbleiterbauelement nach einem der vorangehenden Ansprüche,
**dadurch gekennzeichnet, daß**
der Halbleiterchip im Betrieb UV-Strahlung emittiert.

11. Halbleiterbauelement nach einem der vorangehenden Ansprüche,
**dadurch gekennzeichnet, daß** die Umhüllungsmasse (4) den Wall (23) und die Verankerungselemente (24) vollständig abdeckt.

12. Halbleiterbauelement nach einem der vorangehenden Ansprüche,
**dadurch gekennzeichnet, daß**
die Umhüllungsmasse (4) auf ihrer vom Leuchtdiodenchip (1) abgewandten Seite eine konkave Oberfläche aufweist.

## Claims

1. Radiation-emitting and/or -receiving semiconductor component comprising at least one radiation-emitting and/or -receiving semiconductor chip (1) which is arranged in a recess (2) of an integral housing main body (3) and is covered there with an encapsulation element (4), which is highly transmissive to electromagnetic radiation emitted and/or received by the semiconductor chip (1), wherein
the housing main body has in the recess (2) a chip trough (21), in which the semiconductor chip (1) is fixed, and a trench (22) extending at least partly circumferentially around the chip trough (21), in such a way that between the chip trough (21) and the trench (22) the housing main body (3) has a wall (23), the apex of which, as seen from a bottom area of the chip trough (21) lies below the level of that surface of the housing main body (3) from which the recess (2) leads into the housing main body (3),
- the encapsulation compound (4) is embodied in an integral fashion and, in order to reduce the risk of a delamination between encapsulation compound (4) and housing main body (3), extends out of the chip trough (21) over the wall into the trench (22)
**characterized in that** at least one anchoring element (24) which projects into the encapsulation compound is formed at the wall (23).

2. Semiconductor component according to Claim 1,
**characterized in that**
the encapsulation compound (4) has a gel-like consistency.

3. Semiconductor component according to Claim 1 or 2,
**characterized in that**
a plurality of the anchoring elements (24) are arranged in a distributed fashion onto the wall (23), which anchoring elements project into the encapsulation compound proceeding from the wall.

4. Semiconductor component according to Claim 3,
**characterized in that**
the anchoring elements (24) are distributed uniformly around the chip trough at the wall.

5. Semiconductor component according to any of the preceding claims,
**characterized in that**
the anchoring element(s) (24) is (are) embodied as anchoring lug(s) or rib(s) projecting from the wall and the encapsulation compound (4) is placed in a looplike manner around the anchoring element(s) (24), in such a way that the anchoring element(s) (24) projects (project) at least partly from the encapsulation compound (4).

6. Semiconductor component according to any of the preceding claims,
**characterized in that**
the anchoring element(s) is (are) embodied as anchoring lug(s) or rib(s) projecting from the wall and the encapsulation compound (4) spans the anchoring element(s).

7. Semiconductor component according to any of the preceding claims,
**characterized in that**
the chip trough (21) is embodied as a reflector trough for the radiation emitted and/or received by the semiconductor chip.

8. Semiconductor component according to any of the preceding claims,
**characterized in that**
at least one phosphor material (7) which absorbs part of the radiation emitted by the semiconductor chip and emits radiation having a changed wavelength in comparison with the absorbed radiation is mixed into the encapsulation compound (4).

9. Semiconductor component according to any of the preceding claims,
**characterized in that**
the wall has at least one cutout (52) through which at least one chip connection wire (5) is led from the semiconductor chip (1) to a wire connection region (51) of an electrical connection conductor (61) of the component.

10. Semiconductor component according to any of the preceding claims,
**characterized in that**
the semiconductor chip emits UV radiation during operation.

11. Semiconductor component according to any of the preceding claims,
**characterized in that**
the encapsulation compound (4) completely covers the wall (23) and the anchoring elements (24).

12. Semiconductor component according to any of the preceding claims,
**characterized in that**
the encapsulation compound (4) has a concave surface on its side facing away from the light-emitting diode chip (1).

## Revendications

1. Composant à semiconducteur émettant et/ou recevant un rayonnement, comportant au moins une puce à semiconducteur émettant et/ou recevant un rayonnement (1), qui est disposé dans une ouverture (2) d'un corps de boîtier d'un seul tenant (3) et qui est recouvert d'un élément d'enrobage (4) hautement transparent à un rayonnement électromagnétique émis et/ou reçu par une puce à semiconducteur (1), dans lequel
le corps de boîtier, dans l'ouverture (2), comprend une cuve à puce (21) dans laquelle est fixée la puce à semiconducteur (1), et une tranchée (22) entourant au moins partiellement la cuve à puce (21) de telle manière que le corps de boîtier (3) présente, entre la cuve à puce (21) et la tranchée (22) du corps de boîtier (3), une crénelure (23) dont le sommet, vu depuis une surface inférieure de la cuve à puce (21), se situe en dessous du niveau de la surface de corps de boîtier (3) qui conduit de l'ouverture (2) dans le corps de boîtier (3),
- la masse d'enrobage (4) est réalisée d'un seul tenant et, pour réduire le risque de déstratification entre la masse d'enrobage (4) et le corps du boîtier (3), s'étend en dehors de la cuve à puce (21) au-dessus de la crénelure pour pénétrer dans la tranchée (22),
**caractérisé en ce qu'**au moins un élément d'ancrage (24) qui fait saillie dans la masse d'enrobage est formé sur la crénelure (23).

2. Composant à semiconducteur selon la revendication 1, **caractérisé en ce que** la masse d'enrobage (4) présente la consistance d'un gel.

3. Composant à semiconducteur selon la revendication 1 ou 2, **caractérisé en ce qu'**une pluralité d'éléments d'ancrage (24) sont disposés de
manière répartie sur la crénelure (23), ceux-ci faisant saillie par rapport à la crénelure dans la masse d'enrobage.

4. Composant à semiconducteur selon la revendication 3, **caractérisé en ce que** les éléments d'ancrage (24) sont uniformément répartis sur la crénelure autour de la cuve à puce.

5. Composant à semiconducteur selon l'une quelconque des revendications précédentes, **caractérisé en ce que** l'élément ou les éléments d'ancrage (24) est/sont réalisé(s) sous la forme d'un ou deux nez ou nervure(s) d'ancrage faisant saillie par rapport à la crénelure et **en ce que** la masse d'enrobage (4) est disposée autour du ou des élément(s) d'ancrage (24) sous la forme d'une boucle de telle manière que le ou les élément(s) d'ancrage (24) fasse/fassent au moins partiellement saillie par rapport à la masse d'enrobage (4).

6. Composant à semiconducteur selon l'une quelconque des revendications précédentes, **caractérisé en ce que** le/les élément(s) d'ancrage est/sont réalisé(s) sous la forme de nez ou de nervure(s) d'ancrage faisant saillie et **en ce que** la masse d'enrobage (4) recouvre le/les élément(s) d'ancrage.

7. Composant à semiconducteur selon l'une quelconque des revendications précédentes, **caractérisé en ce que** la cuve à puce (21) est réalisée sous la forme d'une cuve réfléchissant le rayonnement émis et/ou reçu par la puce à semiconducteur.

8. Composant à semiconducteur selon l'une quelconque des revendications précédentes, **caractérisé en ce que**, dans la masse d'enrobage (4), est mélangé au moins un matériau luminescent (7) qui absorbe une partie du rayonnement émis par la puce à semiconducteur et émet un rayonnement ayant des longueurs d'onde modifiées par comparaison au rayonnement absorbé.

9. Composant à semiconducteur selon l'une quelconque des revendications précédentes, **caractérisé en ce que** la crénelure comprend au moins un évidement (52) à travers lequel au moins un fil de raccordement de puce (5) est acheminé de la puce à semiconducteur (1) vers une zone de connexion par fil (51) d'un conducteur de raccordement électrique (61) du composant.

10. Composant à semiconducteur selon l'une quelconque des revendications précédentes, **caractérisé en ce que** la puce à semiconducteur émet un rayonnement UV lors de son fonctionnement.

11. Composant à semiconducteur selon l'une quelconque des revendications précédentes, **caractérisé en ce que** la masse d'enrobage (4) recouvre entièrement la crénelure (23) et les éléments d'ancrage (24).

12. Composant à semiconducteur selon l'une quelconque des revendications précédentes, **caractérisé en ce que** la masse d'enrobage (4) présente sur sa face opposée à la puce de diode électroluminescente (1) une surface concave.
